# EUROPEAN PATENT SPECIFICATION

(11) **EP 1 410 475 B1**
(45) Date of publication and mention of the grant of the patent: **06.04.2016**
(21) Application number: 02706690.1
(22) Date of filing: 19.03.2002
(51) Int. Cl.: H01S 5/0683

(54) **OPTICAL FEEDBACK SYSTEM**
OPTISCHES ZURÜCKGEKOPPELTES SYSTEM
SYSTEME DE RETOUR OPTIQUE

(30) Priority: 30.03.2001 US 279683 P; 13.11.2001 US 331254 P
(43) Date of publication of application: 21.04.2004
(73) Proprietor: MedArt A/S, 2650 Hvidovre (DK)
(72) Inventor: BRUUN-LARSEN, Morten, DK-2100 København Ø (DK); BALLE-PETERSEN, Olav, DK-2980 Kokkedal (DK)
(74) Representative: Zacco Denmark A/S
(86) International application number: PCT/DK2002/000181
(87) International publication number: WO 2002/080316

(56) References cited:
- US-A- 4 053 236
- US-A- 4 431 258
- US-A- 4 842 404
- US-A- 5 640 257
- US-A- 5 757 831
- US-A- 6 128 133
- PATENT ABSTRACTS OF JAPAN vol. 012, no. 217 (E-624), 21 June 1988 (1988-06-21) & JP 63 013390 A (OMRON TATEISI ELECTRONICS CO), 20 January 1988 (1988-01-20)
- PATENT ABSTRACTS OF JAPAN vol. 006, no. 259 (E-149), 17 December 1982 (1982-12-17) & JP 57 155789 A (MITSUBISHI DENKI KK), 25 September 1982 (1982-09-25)

## Description

### FIELD OF THE INVENTION

The present invention relates to a system and a method for generating an optical feedback for controlling the output power of a light source, such as a high power light source, preferably such as a high power laser, for example such as a high power semiconductor laser.

### BACKGROUND OF THE INVENTION

High power light sources, such as high power lasers, are widely used in all kind of technical fields. Semiconductor lasers are compact in size, reasonable in price and are capable of emitting a high power laser beam and are, thus, widely used. It is, though, a disadvantage that the properties of the semiconductor lasers may degenerate over time.

Furthermore, the wavelength of the light beam emitted from a semiconductor laser is highly temperature dependent so that a change in wavelength may be seen when the temperature of the semiconductor laser is changed. The temperature of the semiconductor laser is for example increased when heat emitted from the laser is dissipated in the laser structure itself. Since many of the optical components in a semiconductor laser setup are wavelength dependent, the optical output power may also be changed when the wavelength is changed.

It is, therefore, normally necessary to control the amount of power emitted from a semiconductor laser. It is usually preferred to monitor the output power of the laser diode assembly continuously and control the drive current of the laser diode assembly accordingly so that the output power is kept at a constant level. Alternatively, frequent calibrations may be performed on the apparatus.

A well known principle for measuring the power emitted from a semiconductor laser is to position a detector inside the laser diode assembly. Hereby, the light emitted from the laser diode is measured directly. It is, though, a disadvantage that the detector positioned in the laser diode assembly is very sensitive to back reflected light. The amount of power detected will, thus, typically include a contribution from light returned back into the laser diode.

To overcome this disadvantage, a detector has been positioned off-axis from the laser light beam emitted from the laser diode assembly to thereby detect the light scattered from the output light beam. By measuring the scattered light, the sensitivity to back reflected light is reduced but still not eliminated and, furthermore, the precision of the power measured with this method may not be as high as required.

For low power lasers, an alternative method of measuring the power of the output light beam has been to insert a beamsplitter in the path of the output light beam so that a small part of the output light beam (a secondary light beam) is transmitted through the beamsplitter for detection whereas the rest of the beam (the primary light beam) is reflected (or vice versa). This is possible for a relatively low power laser light beam whereas new problems arise when a high power laser light beam is transmitted through a standard beamsplitter where variations of up to 50 % of the transmittance in a given wavelength range is not unusual.

The beamsplitter is normally provided with a dielectric coating allowing for transmittance/reflection of specific parts of the output light beam as described above. Typically, this coating is designed so that the beamsplitter transmits a specific percentage of the output light beam at a specific wavelength, the power of the transmitted light beam then being detected by the detector. However, the wavelength of a light beam emitted from the laser diode assembly is dependent on the temperature of the laser diode assembly. Hereby, the wavelength of the output light beam may change according to the temperature variations of the semiconductor laser whereby the transmittance of the dielectric coated beamsplitter is changed. The detected power of the secondary light beam will then not represent a fixed percentage of the primary output light beam, but may experience a deviation of up to 50 % of the expected transmittance so that the power of the primary output light beam may deviate up to 50 % from a predetermined output power level.

An optical system as described above is, e.g., described in US Patent No. 5,757,831. Thus, US 5,757,831 describes a solid state laser in which the output is stabilized by means of a feedback signal which is generated on the basis of the beam intensity by means of a secondary beam. However, the power of the secondary beam is not kept at a substantially fixed percentage of the power of the primary output beam, and the optical system must therefore be expected to suffer from the drawbacks mentioned above.

Japanese Patent Application No. 63 013390 (Patent Abstracts of Japan vol. 012, no. 217) describes an optical system for stabilizing the intensity of an optical output by directly monitoring front light in output light from a semiconductor laser. A secondary beam is obtained by means of a beamsplitter, and the intensity of the optical output is controlled on the basis of the secondary beam. However, the power of the secondary beam is not kept at a substantially fixed percentage of the power of the primary beam, and the system must therefore be expected to suffer from the drawbacks described above.

### SUMMARY OF THE INVENTION

It Is an object of the present invention to provide a system for detection of the power of the high power output light beam from a light source.

It is a further object of the present invention to provide a system for detection of the power of a secondary light beam without receiving any false contribution from back reflected light.

It is a still further object of the present invention to provide a system for detection of the output power of a light beam emitted from a light source, the accuracy of the detected output power being within +/- 20 % of a predetermined power level.

It is still another object of the present invention to provide a system for detection of the output power of a light beam emitted from a light source, the accuracy of the detected output power being within +/- 10 % of a predetermined power level.

It is a further object of the present invention to provide a feedback signal from the detector to the light source so that the parameters of the light source are adjusted according to the feedback signal so as to keep the output power at the predetermined power level.

According to a first aspect of the invention, the above-mentioned and other objects are fulfilled by an optical system comprising
a light source for emission of a first light beam
a first beamsplitter being adapted to transmit/reflect a secondary output light beam in response to said first light beam being incident upon said beamsplitter, and further being adapted to reflect/transmit a primary output light beam in response to said first light beam being incident upon said beamsplitter, the power of the secondary output light beam being a substantially fixed percentage of the power of the primary output light beam, the substantially fixed percentage being less than 5 %, the substantially fixed percentage being substantially invariant to wavelength variations of the first light beam within a predetermined wavelength range, and
a detector being adapted to measure the power of the secondary output light beam, and providing on the basis of the measured power a control signal to the light source, so that parameters of the light source are adjusted in such a way that the output power of the primary output light beam is kept substantially constant,
wherein
the first beamsplitter has a dielectric coating,
the first beamsplitter, for an incident light beam having a wavelength within the predetermined wavelength range, induces a variation in the power of the transmitted/reflected secondary light beam being within +/-10 % of the power of the transmitted/reflected secondary light beam at a given wavelength within the predetermined wavelength range so as to provide a variation in the substantially fixed percentage of the primary output light beam being within +/-10% of the substantially fixed percentage at the given wavelength, and
the predetermined wavelength range is chosen as in claim 1.

According to a second aspect of the invention, a method of controlling the output of an optical system, the method comprising the steps of:
- emitting, by means of a light source, a first light beam being incident upon a beamsplitter,
- reflecting/transmitting a primary output light beam by means of said beamsplitter in response to the first light beam being incident thereupon,
- transmitting/reflecting a secondary output light beam by means of said beamsplitter in response to the first light beam being incident thereupon, and in such a way that the power of the secondary output light beam is a substantially fixed percentage of the power of the primary output light beam, the substantially fixed percentage being less than 5 %, the substantially fixed percentage being substantially invariant to wavelength variations of the first light beam within a predetermined wavelength range,
- measuring the power of the secondary output light beam,
- providing, on the basis of the measured power, a control signal to the light source, and
- adjusting parameters of the light source so that the first light beam is emitted in such a way that the output power of the primary output light beam is kept substantially constant,
   wherein
- the first beamsplitter has a dielectric coating,
- the first beamsplitter, for an incident light beam having a wavelength within the predetermined wavelength range, is adapted to induce a variation in the power of the transmitted/reflected secondary light beam being within +/-10 % of the power of the transmitted/reflected secondary light beam at a given wavelength within the predetermined wavelength range so as to provide a variation in the substantially fixed percentage of the primary output light beam being within +/-10% of the substantially fixed percentage at the given wavelength, and
- the predetermined wavelength range is chosen as in claim 18.

The substantially fixed percentage of the secondary output light beam Is a percentage which is substantially invariant to wavelength variations of the first light beam within a predetermined wavelength range.

Furthermore, the substantially fixed percentage is a percentage which is substantially invariant to temperature changes of the beamsplitter because the dielectric coating is chosen to absorb only a small amount of water during manufacturing. The water content of the dielectric coating may otherwise change the transmittance/reflection characteristics of the beamsplitter when the beamsplitter is subjected to temperature variations during operation. The transmittance and/or reflection spectra of the beamsplitter provided with the dielectric coating may, thus, be substantially invariant to wavelength changes of the first light beam in a predetermined wavelength range and further invariant to temperature changes of the coated beamsplitter.

The substantially fixed percentage is less 5 %, such as less than 1 %, such as less than 0.5 %, for example such as less than 0.1 %, such as approximately 0.05 %, such as less than 0.05 %, such as approximately 0.01 %, of the power of the primary output light beam.

It is an important advantage that the substantially fixed percentage is invariant to wavelength variations of the first light beam within a predetermined wavelength range. In a preferred embodiment of the invention, the first light source may comprise one or more semiconductor laser(s), such as semiconductor diode laser(s), and since the wavelength of the emitted light beam from such semiconductor laser(s) is dependent on the temperature of the semiconductor laser, the wavelength of the emitted light beam may change with the temperature. The wavelength dependence may for example be 3 nm per 10 °Celsius and especially when using high power light sources, the temperature increase of the semiconductor laser(s) may be significant, such as above 10 °C, such as around 15 °C, such as around 20 °C.

Furthermore, the wavelength of light emitted from a specific light source provided by different manufacturers may be shown to differ from one manufacturer to another, and the wavelength may even be shown to differ within one manufacturer from one lot to another.

In an embodiment, the first light source comprises a semiconductor diode laser, such as an AlGaAs diode laser emitting a light beam with a wavelength around 805 nm. In this embodiment, the predetermined wavelength range may, thus, be chosen to range from approximately 780 nm to approximately 830 nm. In other embodiments, other semiconductor diode lasers may be used, such as GaInAsP, GaAsP, InP, etc, and a predetermined wavelength range, preferably centered around a center wavelength of the chosen semiconductor laser, may be selected so that the predetermined wavelength range may be chosen to range from approximately 620 nm to approximately 650 nm, from approximately 910 nm to approximately 1100 nm, such as from approximately 910 nm to approximately 960 nm, such as approximately 980 nm, approximately 1030 nm, or approximately 1064 nm, from approximately 1450 nm to approximately 1550 nm, from approximately 1600 nm to approximately 1900 nm, such as from approximately 1700 nm to approximately 1900 nm, such as approximately 1800 nm, or approximately 1680 nm, from approximately 520 nm to approximately 585 nm, such as from approximately 578 nm to approximately 585 nm, such as approximately 532 nm, etc.

It is envisaged that also other lasers may be chosen. For example, solid state lasers, such as Nd YAG lasers, such as frequency doubled Nd YAG lasers, such as CO₂ lasers, YAG lasers, such as Erbium YAG lasers, Holmium YAG lasers, Nd YAG lasers, etc., pulsed lasers, gas lasers, solid state lasers, Hg lasers, excimer lasers, wavelength tuneable lasers, such as Optical Parametric Oscillators (OPO's), etc.

Hereby, the predetermined wavelength range may be chosen to be centered around wavelengths emitted by, for example, solid state lasers, such as centered around 515 nm, 532 nm, 1.03 µm, 1.064µm, or, as an other example, using a wavelength tuneable laser, such as an optical parametric oscillator, and choosing the predetermined wavelength range to be between approximately 578 nm and approximately 585 nm.

It is an advantage of using the method of the invention in combination with the other lasers mentioned above that the power of the output light beam is, hereby, measured without any influence from back reflected light and independently of any temperature changes of the coated beamsplitter.

In an embodiment, the incident light beam has a wavelength within a predetermined wavelength range, and the beamsplitter may induce a variation in the power of the transmitted/reflected secondary light beam being within +/-10 %, such as within +/-5 %, of the power of the transmitted/reflected secondary light beam at a given wavelength within the predetermined wavelength range so as to provide a variation in the substantially fixed percentage of the primary output light beam being within +/-10 % of the substantially fixed percentage at the given wavelength, such as for example within +/-5 % of the substantially fixed percentage at the given wavelength.

In another preferred embodiment, the incident light beam has a wavelength within a predetermined wavelength range, and the beamsplitter may induce a variation in the power of the transmitted/reflected secondary light beam being within +/-10 %, such as within +/- 5%, of the average power of the transmitted/reflected secondary light beam in the given wavelength range so as to provide a variation in the substantially fixed percentage of the primary output light beam being within +/-10 % of the average power of the transmitted/reflected secondary output light beam in the predetermined wavelength range, such as for example within +/- 5 % of the average power of the transmitted/reflected secondary output light beam in the predetermined wavelength range. The output power of the primary output light beam is, preferably, kept within +/- 20 % of a predetermined output power, such as for example within +/-10 % of the predetermined output power. It is an important advantage of the herein described detection system that the overall variation of the output power may be kept within these limits as the law lays down that the variation of the power output of a laser for use in medical treatment should be limited to +/- 20 %.

For example in medical treatment, it is crucial to limit the variation of the output power of the applied laser to ensure a uniform treatment of the patients. In the medical industry, an effort is made to develop treatment patterns, etc. to obtain a uniform treatment of e.g. a skin area to be treated. In order to obtain a consistent and uniform treatment, e.g. throughout the day or throughout the month, it is of importance that the real value of the output power is known. Even though frequent calibrations may be performed to ensure uniform output treatment, these calibrations do not take, for example, temperature changes during the day into account. Furthermore, continuous monitoring of the output power is more convenient for the operator of the system since no additional procedures are required for calibrations of the system.

To obtain a beamsplitter capable of providing transmittance/reflection spectra having a very low variation in transmittance/reflection, the beamsplitter may be coated with a multi-layer dielectric coating. The coating of the beamsplitter may preferably comprise a number of alternating layers having different indices of refraction, for example so that each of the alternating layers has an index of refraction being significant of said layer. In a preferred embodiment, the alternating layers comprise alternating layers of titanium-dioxide (TiO₂) and quartz (SiO₂). It should, however, be envisaged that also other dielectric materials may be used to obtain a coating having the desired properties. The number of layers may depend on the manufacturing process and may be for example more than 20, such as more than 40, such as more than 60, such as more than 80, or even such as more than 100 layers.

Preferably, the indices of refraction of the alternating layers are chosen within a range from approximately 1.2 to approximately 2.5. The dielectric coating may for example comprise at least a first layer having an index of refraction being within a range from approximately 1.2 to approximately 1.6, and at least a second layer having an index of refraction being within a range from approximately 2.0 to approximately 2.5. It is, though, envisaged that the optimum thicknesses and/or indices of refraction being dependent on the light source used and the wavelength emitted from the light source. Furthermore, the thickness of the layers may be tightly controlled according to the wavelength of the light to be incident on the specific coating, and it is further preferred to manufacture the dielectric coating so that the water content of the coating is minimized.

It is, thus, to be understood that the dielectric coating is manufactured so as to provide a match between the dielectric coating and the emitted wavelength of the specific light source to be used in a specific system.

### BRIEF DESCRIPTION OF THE DRAWINGS.

In the following, a preferred embodiment of an optical system will be described with reference to the drawings, wherein
Fig. 1 shows a schematic view of an optical feedback system of a reflective type,
Fig. 2 shows a schematic view of an optical feedback system of a transmissive type,
Fig. 3 illustrates the wavelength dependent variation in transmittance/reflectance of a beamsplitter of reflective/transmissive type, and
Fig. 4 shows the transmittance of a secondary light beam as a function of wavelength, using a beamsplitter having a preferred dielectric coating.

### DETAILED DESCRIPTION OF THE DRAWINGS

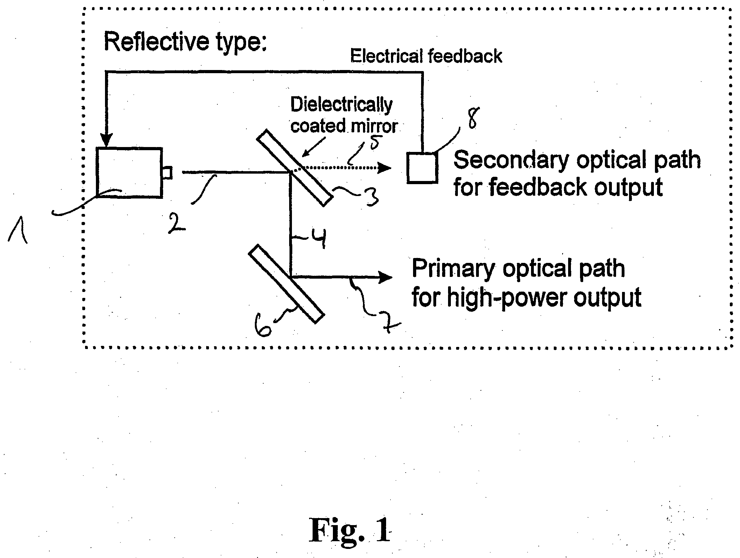

Fig. 1 shows an optical feedback system of a reflective type comprising a light source 1 for emission of a first light beam 2 being incident upon a dielectrically coated mirror 3 (a beamsplitter). The beamsplitter 3 reflects a primary output light beam 4 and transmits a secondary output light beam 5. The beamsplitter is thus of the reflective type. The beamsplitter 3 is designed in such a way that the power of the secondary output light beam 5 constitutes a substantially fixed percentage of the power of the primary output light beam 4.

The primary output light beam 4 is reflected onto a second mirror 6 from which it is reflected so as to obtain a high power primary output light beam 7.

The secondary output light beam 5, on the other hand, is fed into a detector 8 for measuring the power of the secondary output light beam 5. The detector 8 produces an electrical feedback signal in response to the secondary output light beam 5. The electrical feedback signal is in turn communicated to the first light source 1. Since the power of the secondary output light beam 5 constitutes a substantially fixed percentage of the power of the primary output light beam 7, the measured power provides a measure of the power of the primary output light beam 7.

Responsive to the received electrical feedback signal, parameters of the first light source 1 may be adjusted so that the first light beam 2 emitted from the first light source 1 is adjusted so as to keep the power of the primary output light beam 7 substantially constant. The parameters of the light source may comprise the current supplied to the light source, the current being adjusted so as to keep the power of the primary output light beam substantially constant. It is envisaged that also other light source parameters suitable for dynamic adjustment of the laser power may be used.

Thus, the power of the primary output light beam may be continuously monitored by monitoring the secondary output light beam, and the power of the light source may be adjusted if necessary so that the power of the primary output light beam may be kept substantially constant. Thereby, an output light beam having a substantially constant power, i.e. a very stable output beam, is provided. This is particularly useful, e.g. for treatment of skin disorders and for other medical uses of the primary output light beam in order to obtain a uniform treatment. Furthermore, in order to obtain an approval of medical use of a light source, such as a laser, it is a requirement stipulated by the authorities that the power variation of the output light beam is below +/- 20 %.

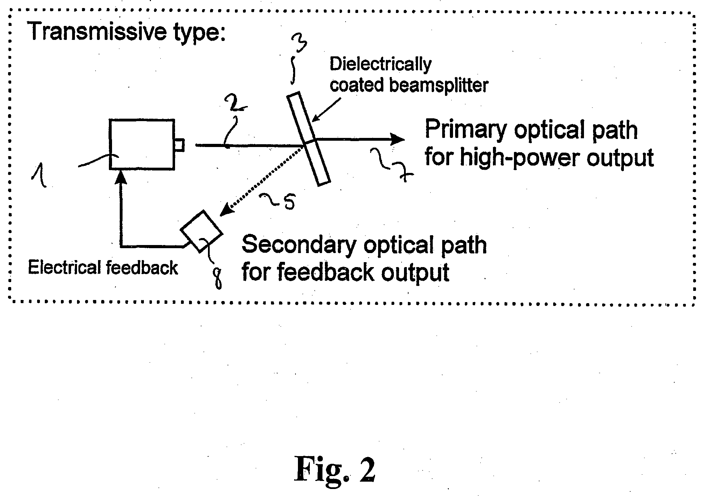

Fig. 2 shows another optical feedback system, the feedback system being of a transmissive type and comprising a first light source 1, a beamsplitter 3, and a detector 8 as described above. However, in this case the beamsplitter 3 is a transmissive type beamsplitter 3, and the primary output light beam 7 is transmitted through the beamsplitter 3 while the secondary output light beam 5 is reflected from the beamsplitter 3.

Both the reflective and the transmissive type of feedback system may be equally applied.

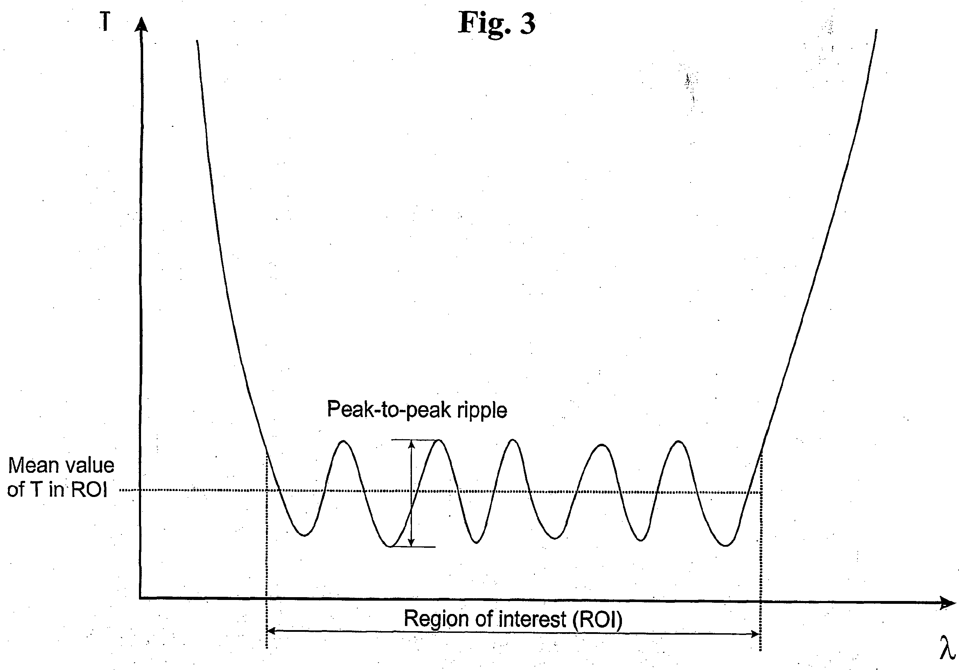

Fig. 3 shows the transmittance/reflectance of beamsplitter 3 of reflective/transmissive type (i.e. corresponding to the secondary output light beam) as a function of wavelength. This figure illustrates the variation in transmittance/reflectance (the ripple) of the beamsplitter 3 in a wavelength region of interest. The variation in transmittance/reflectance of the beamsplitter will closely correlate to the variation in power of the secondary light beam transmitted through/reflected from the beamsplitter. The wavelength region of interest is an interval of wavelengths comprising wavelengths at which it, according to the light source applied to the system, is desirable and/or advantageous to operate the device.

In order to obtain a high throughput of the system with as little loss as possible, the fixed percentage should be as small as possible. Thus, the power of the secondary output light beam may constitute only a very small percentage of the power of the primary output light beam, such as 0.05 % - 0.1 %. Thus, the secondary output light beam is preferably a very weak beam. In order to obtain a precise measure of the power of the primary output light beam as described above, the measurement of the power of the secondary output light beam should be as precise as possible. Therefore, it is crucial that variations in the transmittance/reflectance of the beamsplitter 3 are minimized within the wavelength region of interest. When the secondary output light beam constitutes only a very small part of the primary output light beam, variations in transmittance/reflectance of the beamsplitter 3 may easily be of the same order of magnitude as the transmittance/reflectance of the beamsplitter 3 in the wavelength region of interest when using conventional dielectric coatings. Hereby, the percentage of the first light beam 2 transmitted through/reflected from the beamsplitter 3 will not be a substantially fixed percentage of the primary output light beam but may vary up to 50 % or even up to 100 % in the wavelength region of interest.

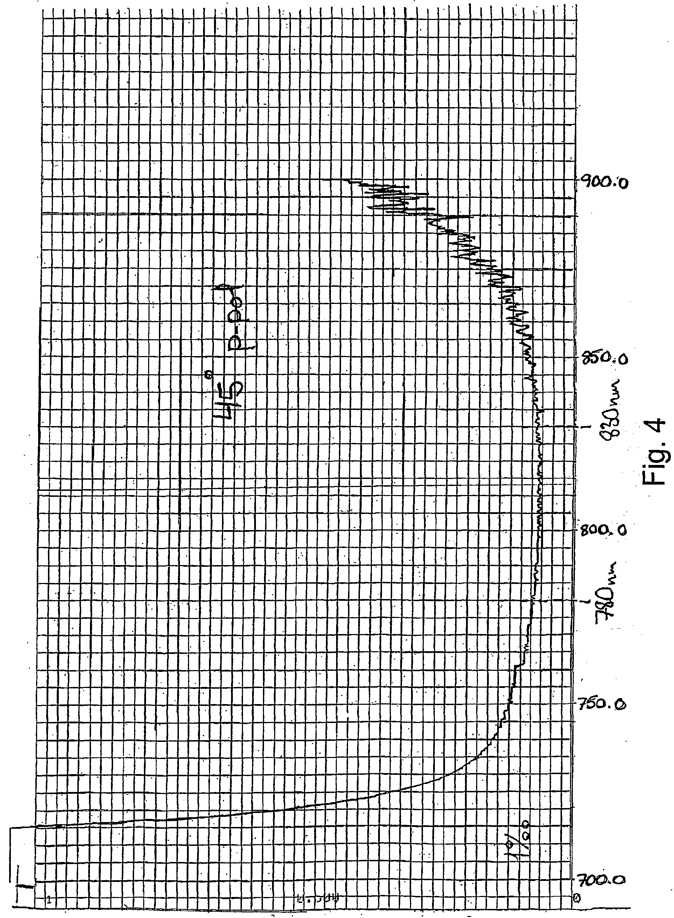

It is an advantage of the present invention that the variation of the transmittance/reflectance of the beamsplitter 3 corresponds to approximately +/- 5 % of the transmittance/reflectance at a specific wavelength (805 nm cf. Fig. 4). The variation in power of the secondary output light beam introduced by the beamsplitter is thus so small that a useful measurement can be obtained. This is necessary in order to control the power of the primary output light beam in a satisfactorily manner.

In Fig. 3 the transmittance/reflectance of the beamsplitter is very low in the region of interest. The variations are shown as deviations from a mean value of the transmittance/reflectance. The maximum deviations are referred to as the peak-to-peak ripple. The peak-to-peak ripple should constitute only a small fraction of the mean transmittance/reflectance in the wavelength region of interest and/or of the transmittance/reflectance at a certain specified wavelength. The small fraction is preferably below +/-10 %, most preferably at or below +/- 5 %.

Fig. 4 shows the transmittance spectrum, i.e. the transmittance as a function of wavelength, of a reflective type beamsplitter 3 being coated with a preferred dielectric coating. The dielectric coating is an ultra-hard coating manufactured by DELTA Light and Optics, Lyngby, Denmark. The coating comprises 80 alternating layers of TiO₂ and SiO₂ The dielectric coating is adapted to a wavelength region of interest being between 780 nm and 830 nm. The coating has a reflectance which is greater than 99.8 % for s and p polarized light in the wavelength region of interest. The transmittance is 0.05 % 0.15 % for p polarized light at 805 nm, and the variation of the transmittance (the ripple) is +/- 5 % of the transmittance at 805 nm within the wavelength region of interest.

The beamsplitter is manufactured in BK7, or an equivalent material, and the flatness of the coated area is lambda/10 over the coated area, where lambda is the center wavelength for which the coating is designed, i.e. 805 nm for this coating. The quality of the surface is 60-40 Scratch and Dig. The thickness of the beamsplitter is 1 mm and the length and width of the beamsplitter are 16 mm and 12 mm, respectively. The beamsplitter may be used with light beam intensities of at least less than 2 kW/cm² (for continuous wave light beams), as is specified for this specific coating.

It is clear from Fig. 4 that the variation, introduced by the beamsplitter, of the transmitted power of the secondary output light beam constitutes a very small fraction of the transmitted power. By using this particular coating it is, therefore, possible to obtain a precise measurement of the transmitted secondary output power even though the transmittance is low due to a desire of obtaining a high throughput of the system. It is, thus, possible to obtain a useful feedback signal which may be used to control the power of the primary output light beam in order to keep this substantially constant, while at the same time providing a high throughput of the system, i.e. without sacrificing too much of the input power for feedback purposes. It is a further advantage of being able to obtain a secondary light beam being only a small fraction of the power of the primary light beam that the power of the secondary light beam is easily handled by the feedback system. An increased power of the secondary light beam may lead to over-exposure of the detector, etc. Having for example a 90 W laser, 1% corresponds to 90 mW which is easily handled by the feedback system, without too much power to be dissipated in the feedback system.

## Claims

1. An optical system comprising
- a light source (1) for emission of a first light beam (2),
- a first beamsplitter (3) being adapted to transmit/reflect a secondary output light beam (5) in response to said first light beam (2) being incident upon said beamsplitter (3), and further being adapted to reflect/transmit a primary output light beam (4) in response to said first light beam (2) being incident upon said beamsplitter (3), the power of the secondary output light beam (5) being a substantially fixed percentage of the power of the primary output light beam (4), the substantially fixed percentage being less than 5 %, the substantially fixed percentage being substantially invariant to wavelength variations of the first light beam (2) within a predetermined wavelength range, and
- a detector (8) being adapted to measure the power of the secondary output light beam (5), and providing on the basis of the measured power a control signal to the light source (1), so that parameters of the light source (1) are adjusted in such a way that the output power of the primary output light beam (4) is kept substantially constant,
**characterized in that**
- the first beamsplitter (3) has a dielectric coating,
- the first beamsplitter (3), for an incident light beam (2) having a wavelength within the predetermined wavelength range, induces a variation in the power of the transmitted/reflected secondary light beam (5) being within +/-10 % of the power of the transmitted/reflected secondary light beam (5) at a given wavelength within the predetermined wavelength range so as to provide a variation in the substantially fixed percentage of the primary output light beam (4) being within +/-10% of the substantially fixed percentage at the given wavelength, and
- the predetermined wavelength range is chosen from a group consisting of the wavelength ranges: from approximately 520 nm to approximately 585 nm, from approximately 620 nm to approximately 650 nm, from approximately 780 nm to approximately 830 nm, from approximately 910 nm to approximately 1100 nm, from approximately 1450 nm to approximately 1550 nm, and from approximately 1600 nm to approximately 1900 nm.

2. A system according to claim 1, wherein the first beamsplitter (3), for an incident light beam (2) having a wavelength within the predetermined wavelength range, induces a variation in the power of the transmitted/reflected secondary light beam (5) being within +/-10 % of the average power of the transmitted/reflected secondary light beam (5) in the given wavelength range so as to provide a variation in the substantially fixed percentage of the primary output light beam (4) being within +/-10% of the average power of the transmitted/reflected secondary output light beam (5) in the predetermined wavelength range.

3. A system according to claim 1, wherein the first beamsplitter (3), for an incident light beam (2) having a wavelength within the predetermined wavelength range, induces a variation in the power of the transmitted/reflected secondary light beam (5) being within +/-5 % of the power of the transmitted/reflected secondary light beam (5) at a given wavelength within the predetermined wavelength range so as to provide a variation in the substantially fixed percentage of the primary output light beam (4) being within +/-5 % of the substantially fixed percentage at the given wavelength.

4. A system according to claim 1, wherein the first beamsplitter (3), for an incident light beam (2) having a wavelength within the predetermined wavelength range, induces a variation in the power of the transmitted/reflected secondary light beam (5) being within +/-5 % of the average power of the transmitted/reflected secondary light beam (5) in the given wavelength range so as to provide a variation in the substantially fixed percentage of the primary output light beam (4) being within +/-5 % of the average power of the transmitted/reflected secondary output light beam (5) in the predetermined wavelength range.

5. A system according to claim 1, wherein the output power of the primary output light beam (4) is kept within +/-20% of a predetermined output power.

6. A system according to claim 1, wherein the output power of the primary output light beam (4) is kept within +/-10 % of the predetermined output power.

7. A system according to any of claims 1-6, wherein the transmittance and/or reflection spectra of the dielectric coating of the beamsplitter (3) is/are substantially invariant to temperature changes of the dielectric coating.

8. A system according to any of claims 1-7, wherein the substantially fixed percentage is less than 0.5%.

9. A system according to any of claims 1-8, wherein the substantially fixed percentage is less than 0.1 %.

10. A system according to any of claims 1-9, wherein the light source (1) comprises a solid state laser light source.

11. A system according to any of claims 1-10, wherein the light source (1) comprises a wavelength tuneable laser light source.

12. A system according to any of claims 1-11, wherein the dielectric coating comprises a number of alternating layers having different indices of refraction.

13. A system according to claim 12, wherein each of the alternating layers has an index of refraction being significant of said layer.

14. A system according to claim 12 or 13, wherein the indices of refraction of the alternating layers being within a range from approximately 1.2 to approximately 2.5.

15. A system according to any of claims 12-14, wherein the dielectric coating comprises at least a first layer having an index of refraction being within a range from approximately 1.2 to approximately 1.6, and at least a second layer having an index of refraction being within a range from approximately 2.0 to approximately 2.5.

16. A system according to any of claims 1-15, wherein the dielectric coating comprises alternating layers of titanium-dioxide (TiO₂) and quartz (SiO₂).

17. A system according to any of claims 1-16, wherein the water content of the dielectric coating is minimized.

18. A method of controlling the output of an optical system, the method comprising the steps of:
- emitting, by means of a light source (1), a first light beam (2) being incident upon a beamsplitter (3),
- reflecting/transmitting a primary output light beam (4) by means of said beamsplitter (3) in response to the first light beam (2) being incident thereupon,
- transmitting/reflecting a secondary output light beam (5) by means of said beamsplitter (3) in response to the first light beam (2) being incident thereupon, and in such a way that the power of the secondary output light beam (5) is a substantially fixed percentage of the power of the primary output light beam (4), the substantially fixed percentage being less than 5 %, the substantially fixed percentage being substantially invariant to wavelength variations of the first light beam (2) within a predetermined wavelength range,
- measuring the power of the secondary output light beam (5),
- providing, on the basis of the measured power, a control signal to the light source (1), and
- adjusting parameters of the light source (1) so that the first light beam (2) is emitted in such a way that the output power of the primary output light beam (4) is kept substantially constant,
**characterized in that**
- the first beamsplitter (3) has a dielectric coating,
- the first beamsplitter (3), for an incident light beam (2) having a wavelength within the predetermined wavelength range, is adapted to induce a variation in the power of the transmitted/reflected secondary light beam (5) being within +/-10 % of the power of the transmitted/reflected secondary light beam (5) at a given wavelength within the predetermined wavelength range so as to provide a variation in the substantially fixed percentage of the primary output light beam (4) being within +/-10% of the substantially fixed percentage at the given wavelength, and
- the predetermined wavelength range is chosen from a group consisting of the wavelength ranges: from approximately 520 nm to approximately 585 nm, from approximately 620 nm to approximately 650 nm, from approximately 780 nm to approximately 830 nm, from approximately 910 nm to approximately 1100 nm, from approximately 1450 nm to approximately 1550 nm, and from approximately 1600 nm to approximately 1900 nm.

19. A method according to claim 18, wherein the first beamsplitter (3), for an incident light beam (2) having a wavelength within the predetermined wavelength range, is adapted to induce a variation in the power of the transmitted/reflected secondary light beam (5) being within +/-10 % of the average power of the transmitted/reflected secondary light beam (5) in the given wavelength range so as to provide a variation in the substantially fixed percentage of the primary output light beam (4) being within +/-10% of the average power of the transmitted/reflected secondary output light beam (5) in the predetermined wavelength range.

20. A method according to claim 18, wherein the first beamsplitter (3), for an incident light beam (2) having a wavelength within the predetermined wavelength range, is adapted to induce a variation in the power of the transmitted/reflected secondary light beam (5) being within +/-5 % of the power of the transmitted/reflected secondary light beam (5) at a given wavelength within the predetermined wavelength range so as to provide a variation in the substantially fixed percentage of the primary output light beam (4) being within +/-5 % of the substantially fixed percentage at the given wavelength.

21. A method according to claim 18, wherein the first beamsplitter (3), for an incident light beam (2) having a wavelength within the predetermined wavelength range, is adapted to induce a variation in the power of the transmitted/reflected secondary light beam (5) being within +/-5 % of the average power of the transmitted/reflected secondary light beam (5) in the given wavelength range so as to provide a variation in the substantially fixed percentage of the primary output light beam (4) being within +/-5 % of the average power of the transmitted/reflected secondary output light beam (5) in the predetermined wavelength range.

22. A method according to claim 18, wherein the output power of the primary output light beam (4) is kept within +/-20% of a predetermined output power.

23. A method according to claim 18, wherein the output power of the primary output light beam (4) is kept within +/-10 % of the predetermined output power.

24. A method according to any of claims 18-23, wherein the transmittance and/or reflection spectra of the dielectric coating of the beamsplitter (3) is/are substantially invariant to temperature changes of the dielectric coating.

25. A method according to any of claims 18-24, wherein the substantially fixed percentage is equal to or less than 0.5%.

26. A method according to any of claims 18-25, wherein the substantially fixed percentage is equal to or less than 0.1 %.

27. A method according to any of claims 18-26, wherein the dielectric coating comprises alternating layers of titanium-dioxide (TiO₂) and quartz (SiO₂).

28. A method according to any of claims 18-27, wherein the water content of the dielectric coating is minimized.

## Patentansprüche

1. Optisches System umfassend
- eine Lichtquelle (1) für die Emission eines ersten Lichtstrahls (2),
- einen ersten Strahlteiler (3), der dazu ausgebildet ist, einen sekundären Ausgangslichtstrahl (5) als Antwort auf den ersten Lichtstrahl (2), der auf den Strahlteiler (3) trifft, zu transmittieren/reflektieren, und zusätzlich dazu ausgebildet ist, einen primären Ausgangslichtstrahl (4) als Antwort auf den ersten Lichtstrahl (2), der auf den Strahlteiler (3) trifft, zu reflektieren/transmittieren, wobei die Leistung des sekundären Ausgangslichtstrahls (5) ein im Wesentlichen fester Prozentsatz der Leistung des primären Ausgangslichtstrahls (4) ist, wobei der im Wesentlichen feste Prozentsatz weniger als 5 % beträgt, wobei der im Wesentlichen feste Prozentsatz gegenüber Schwankungen der Wellenlänge des ersten Lichtstrahls (2) innerhalb eines vorgegebenen Wellenlängenbereichs im Wesentlichen unveränderlich ist, und
- einen Detektor (8), der dazu ausgebildet ist, die Leistung des sekundären Ausgangslichtstrahls (5) zu messen, und auf der Basis der gemessenen Leistung ein Steuersignal an die Lichtquelle (1) bereitzustellen, so dass Parameter der Lichtquelle (1) derart justiert werden, dass die Ausgangsleistung des primären Ausgangslichtstrahls (4) im Wesentlichen konstant gehalten wird,
**dadurch gekennzeichnet, dass**
- der erste Strahlteiler (3) eine dielektrische Beschichtung aufweist,
- der erste Strahlteiler (3), für einen auftreffenden Lichtstrahl (2) mit einer Wellenlänge innerhalb des vorgegebenen Wellenlängenbereichs, eine Variation der Leistung des transmittierten/reflektierten sekundären Lichtstrahls (5) verursacht, die innerhalb von +/-10 % der Leistung des transmittierten/reflektierten sekundären Lichtstrahls (5) bei einer gegebenen Wellenlänge innerhalb des vorgegebenen Wellenlängenbereichs liegt, um eine Variation des im Wesentlichen festen Prozentsatzes des primären Ausgangslichtstrahls (4) bereitzustellen, die innerhalb von +/-10 % des im Wesentlichen festen Prozentsatzes bei der gegebenen Wellenlänge liegt, und
- der vorgegebene Wellenlängenbereich aus einer Gruppe ausgewählt ist, die aus den folgenden Wellenlängenbereichen besteht: von etwa 520 nm bis etwa 585 nm, von etwa 620 nm bis etwa 650 nm, von etwa 780 nm bis etwa 830 nm, von etwa 910 nm bis etwa 1100 nm, von etwa 1450 nm bis etwa 1550 nm, und von etwa 1600 nm bis etwa 1900 nm.

2. System nach Anspruch 1, wobei der erste Strahlteiler (3), für einen auftreffenden Lichtstrahl (2) mit einer Wellenlänge innerhalb des vorgegebenen Wellenlängenbereichs, eine Variation der Leistung des transmittierten/reflektierten sekundären Lichtstrahls (5) verursacht, die innerhalb von +/-10 % der durchschnittlichen Leistung des transmittierten/reflektierten sekundären Lichtstrahls (5) in dem gegebenen Wellenlängenbereich liegt, um eine Variation des im Wesentlichen festen Prozentsatzes des primären Ausgangslichtstrahls (4) bereitzustellen, die innerhalb von +/-10 % der durchschnittlichen Leistung des transmittierten/reflektierten sekundären Ausgangslichtstrahls (5) in dem vorgegebenen Wellenlängenbereich liegt.

3. System nach Anspruch 1, wobei der erste Strahlteiler (3), für einen auftreffenden Lichtstrahl (2) mit einer Wellenlänge innerhalb des vorgegebenen Wellenlängenbereichs, eine Variation der Leistung des transmittierten/reflektierten sekundären Lichtstrahls (5) verursacht, die innerhalb von +/-5 % der Leistung des transmittierten/reflektierten sekundären Lichtstrahls (5) bei einer gegebenen Wellenlänge innerhalb des vorgegebenen Wellenlängenbereichs liegt, um eine Variation des im Wesentlichen festen Prozentsatzes des primären Ausgangslichtstrahls (4) bereitzustellen, die innerhalb von +/-5 % des im Wesentlichen festen Prozentsatzes bei der gegebenen Wellenlänge liegt.

4. System nach Anspruch 1, wobei der erste Strahlteiler (3), für einen auftreffenden Lichtstrahl (2) mit einer Wellenlänge innerhalb des vorgegebenen Wellenlängenbereichs, eine Variation der Leistung des transmittierten/reflektierten sekundären Lichtstrahls (5) verursacht, die innerhalb von +/-5 % der durchschnittlichen Leistung des transmittierten/reflektierten sekundären Lichtstrahls (5) in dem gegebenen Wellenlängenbereich liegt, um eine Variation des im Wesentlichen festen Prozentsatzes des primären Ausgangslichtstrahls (4) bereitzustellen, die innerhalb von +/-5 % der durchschnittlichen Leistung des transmittierten/reflektierten sekundären Ausgangslichtstrahls (5) in dem vorgegebenen Wellenlängenbereich liegt.

5. System nach Anspruch 1, wobei die Ausgangsleistung des primären Ausgangslichtstrahls (4) innerhalb von +/-20 % einer vorgegebenen Ausgangsleistung gehalten wird.

6. System nach Anspruch 1, wobei die Ausgangsleistung des primären Ausgangslichtstrahls (4) innerhalb von +/-10 % der vorgegebenen Ausgangsleistung gehalten wird.

7. System nach einem der Ansprüche 1-6, wobei das Transmissions- und/oder Reflexionsspektrum der dielektrischen Beschichtung des Strahlteilers (3) gegenüber Temperaturänderungen der dielektrischen Beschichtung im Wesentlichen unveränderlich ist/sind.

8. System nach einem der Ansprüche 1-7, wobei der im Wesentlichen feste Prozentsatz weniger als 0,5 % beträgt.

9. System nach einem der Ansprüche 1-8, wobei der im Wesentlichen feste Prozentsatz weniger als 0,1 % beträgt.

10. System nach einem der Ansprüche 1-9, wobei die Lichtquelle (1) eine Festkörper-Laserlichtquelle umfasst.

11. System nach einem der Ansprüche 1-10, wobei die Lichtquelle (1) eine Laserlichtquelle mit einstellbarer Wellenlänge umfasst.

12. System nach einem der Ansprüche 1-11, wobei die dielektrische Beschichtung eine Anzahl von abwechselnden Schichten mit verschiedenen Brechungsindizes umfasst.

13. System nach Anspruch 12, wobei jede der abwechselnden Schichten einen Brechungsindex aufweist, der für jede Schicht signifikant ist.

14. System nach Anspruch 12 oder 13, wobei die Brechungsindizes der abwechselnden Schichten im Bereich von etwa 1,2 bis etwa 2,5 liegen.

15. System nach einem der Ansprüche 12-14, wobei die dielektrische Beschichtung zumindest eine erste Schicht mit einem Brechungsindex, der in einem Bereich von etwa 1,2 bis etwa 1,6 liegt, und zumindest eine zweite Schicht mit einem Brechungsindex, der in einem Bereich von etwa 2,0 bis etwa 2,5 liegt, umfasst.

16. System nach einem der Ansprüche 1-15, wobei die dielektrische Beschichtung abwechselnde Schichten von Titaniumdioxid (TiO₂) und Quarz (SiO₂) umfasst.

17. System nach einem der Ansprüche 1-16, wobei der Wassergehalt der dielektrischen Beschichtung minimiert ist.

18. Verfahren zur Steuerung der Ausgabe eines optischen Systems, welches Verfahren die folgenden Schritte umfasst:
- Emittieren, mittels einer Lichtquelle (1), eines ersten Lichtstrahls (2), der auf einen Strahlteiler (3) trifft,
- Reflektieren/Transmittieren eines primären Ausgangslichtstrahls (4) mittels des Strahlteilers (3) als Antwort auf den ersten Lichtstrahl (2), der auf diesen trifft,
- Transmittieren/Reflektieren eines sekundären Ausgangslichtstrahls (5) mittels des Strahlteilers (3) als Antwort auf den ersten Lichtstrahl (2), der auf diesen trifft, und derart, dass die Leistung des sekundären Ausgangslichtstrahls (5) ein im Wesentlichen fester Prozentsatz der Leistung des primären Ausgangslichtstrahls (4) ist, wobei der im Wesentlichen feste Prozentsatz weniger als 5 % beträgt, wobei der im Wesentlichen feste Prozentsatz gegenüber Schwankungen der Wellenlänge des ersten Lichtstrahls (2) innerhalb eines vorgegebenen Wellenlängenbereichs im Wesentlichen unveränderlich ist,
- Messen der Leistung des sekundären Ausgangslichtstrahls (5),
- Bereitstellen, auf der Basis der gemessenen Leistung, eines Steuersignals an die Lichtquelle (1), und
- Justieren von Parametern der Lichtquelle (1) derart, dass der erste Lichtstrahl (2) in einer solchen Weise emittiert wird, dass die Ausgangsleistung des primären Ausgangslichtstrahls (4) im Wesentlichen Konstant gehalten wird,
**dadurch gekennzeichnet, dass**
- der erste Strahlteiler (3) eine dielektrische Beschichtung aufweist,
- der erste Strahlteiler (3), für einen auftreffenden Lichtstrahl (2) mit einer Wellenlänge innerhalb des vorgegebenen Wellenlängenbereichs, dazu ausgebildet ist, eine Variation der Leistung des transmittierten/reflektierten sekundären Lichtstrahls (5) zu verursachen, die innerhalb von +/-10 % der Leistung des transmittierten/reflektierten sekundären Lichtstrahls (5) bei einer gegebenen Wellenlänge innerhalb des vorgegebenen Wellenlängenbereichs liegt, um eine Variation des im Wesentlichen festen Prozentsatzes des primären Ausgangslichtstrahls (4) bereitzustellen, die innerhalb von +/-10 % des im Wesentlichen festen Prozentsatzes bei der gegebenen Wellenlänge liegt, und
- der vorgegebene Wellenlängenbereich aus einer Gruppe ausgewählt ist, die aus den folgenden Wellenlängenbereichen besteht: von etwa 520 nm bis etwa 585 nm, von etwa 620 nm bis etwa 650 nm, von etwa 780 nm bis etwa 830 nm, von etwa 910 nm bis etwa 1100 nm, von etwa 1450 nm bis etwa 1550 nm, und von etwa 1600 nm bis etwa 1900 nm.

19. Verfahren nach Anspruch 18, wobei der erste Strahlteiler (3), für einen auftreffenden Lichtstrahl (2) mit einer Wellenlänge innerhalb des vorgegebenen Wellenlängenbereichs, dazu ausgebildet ist, eine Variation der Leistung des transmittierten/reflektierten sekundären Lichtstrahls (5) zu verursachen, die innerhalb von +/-10 % der durchschnittlichen Leistung des transmittierten/reflektierten sekundären Lichtstrahls (5) in der gegebenen Wellenlängenbereich liegt, um eine Variation des im Wesentlichen festen Prozentsatzes des primären Ausgangslichtstrahls (4) bereitzustellen, die innerhalb von +/-10 % der durchschnittlichen Leistung des transmittierten/reflektierten sekundären Ausgangslichtstrahls (5) in dem vorgegebenen Wellenlängenbereich liegt.

20. Verfahren Anspruch 18, wobei der erste Strahlteiler (3), für einen auftreffenden Lichtstrahl (2) mit einer Wellenlänge innerhalb des vorgegebenen Wellenlängenbereichs, dazu ausgebildet ist, eine Variation der Leistung des transmittierten/reflektierten sekundären Lichtstrahls (5) verursacht, die innerhalb von +/-5 % der Leistung des transmittierten/reflektierten sekundären Lichtstrahls (5) bei einer gegebenen Wellenlänge innerhalb des vorgegebenen Wellenlängenbereichs liegt, um eine Variation des im Wesentlichen festen Prozentsatzes des primären Ausgangslichtstrahls (4) bereitzustellen, die innerhalb von +/-5 % des im Wesentlichen festen Prozentsatzes bei der gegebenen Wellenlänge liegt.

21. Verfahren nach Anspruch 18, wobei der erste Strahlteiler (3), für einen auftreffenden Lichtstrahl (2) mit einer Wellenlänge innerhalb des vorgegebenen Wellenlängenbereichs, dazu ausgebildet ist, eine Variation der Leistung des transmittierten/reflektierten sekundären Lichtstrahls (5) zu verursachen, die innerhalb von +/-5% der durchschnittlichen Leistung des transmittierten/reflektierten sekundären Lichtstrahls (5) in der gegebenen Wellenlängenbereich liegt, um eine Variation des im Wesentlichen festen Prozentsatzes des primären Ausgangslichtstrahls (4) bereitzustellen, die innerhalb von +/-5 % der durchschnittlichen Leistung des transmittierten/reflektierten sekundären Ausgangslichtstrahls (5) in dem vorgegebenen Wellenlängenbereich liegt.

22. Verfahren nach Anspruch 18, wobei die Ausgangsleistung des primären Ausgangslichtstrahls (4) innerhalb von +/-20 % einer vorgegebenen Ausgangsleistung gehalten wird.

23. Verfahren nach Anspruch 18, wobei die Ausgangsleistung des primären Ausgangslichtstrahls (4) innerhalb von +/-10 % einer vorgegebenen Ausgangsleistung gehalten wird.

24. Verfahren nach einem der Ansprüche 18-23, wobei das Transmissions- und/oder Reflexionsspektrum der dielektrischen Beschichtung des Strahlteilers (3) gegenüber Temperaturänderungen der dielektrischen Beschichtung im Wesentlichen unveränderlich ist/sind.

25. Verfahren nach einem der Ansprüche 18-24, wobei der im Wesentlichen feste Prozentsatz gleich oder weniger als 0,5 % ist.

26. Verfahren nach einem der Ansprüche 18-25, wobei der im Wesentlichen feste Prozentsatz gleich oder weniger als 0,1 % ist.

27. Verfahren nach einem der Ansprüche 18-26, wobei die dielektrische Beschichtung abwechselnde Schichten von Titaniumdioxid (TiO₂) und Quarz (SiO₂) umfasst.

28. Verfahren nach einem der Ansprüche 18-27, wobei der Wassergehalt der dielektrischen Beschichtung minimiert wird.

## Revendications

1. Système optique comprenant
- une source de lumière (1) pour l'émission d'un premier faisceau lumineux (2),
- un premier diviseur de faisceau (3) étant adapté pour transmettre/réfléchir un faisceau lumineux de sortie secondaire (5) en réponse audit premier faisceau lumineux (2) étant incident sur ledit diviseur de faisceau (3), et étant en outre adapté pour réfléchir/transmettre un faisceau lumineux de sortie primaire (4) en réponse audit premier faisceau lumineux (2) étant incident sur ledit diviseur de faisceau (3), la puissance du faisceau lumineux de sortie secondaire (5) étant un pourcentage essentiellement fixe de la puissance du faisceau lumineux de sortie primaire (4), le pourcentage essentiellement fixe étant inférieure à 5%, le pourcentage essentiellement fixe étant essentiellement invariant à des variations de longueur d'onde du premier faisceau lumineux (2) dans une plage prédéterminée de longueur d'onde, et
- un détecteur (8) étant adapté pour mesurer la puissance du faisceau lumineux de sortie secondaire (5), et sur la base de la puissance mesurée, fournissant un signal de commande à la source de lumière (1), si bien que les paramètres de la source de lumière (1) sont réglés si bien que la puissance de sortie du faisceau lumineux de sortie primaire (4) est maintenue essentiellement constante,
**caractérisé en ce que**
- le premier diviseur de faisceau (3) présente un revêtement diélectrique,
- le premier diviseur de faisceau (3), pour un faisceau lumineux incident (2) ayant une longueur d'onde dans la plage de longueur d'onde prédéterminée, provoque une variation de la puissance du faisceau lumineux de sortie secondaire (5) transmis/réfléchi étant à +/- 10% de la puissance du faisceau lumineux de sortie secondaire (5) transmis/réfléchi à une longueur d'onde donnée dans la plage de longueur d'onde prédéterminée de façon à fournir une variation du pourcentage essentiellement fixe du faisceau lumineux de sortie primaire (4) étant à +/- 10% du pourcentage essentiellement fixe à la longueur d'onde donnée, et
- la plage de longueur d'onde prédéterminée est choisie d'un groupe composé des plages de longueur d'onde: comprise entre environ 520 nm et environ 585 nm, comprise entre environ 620 nm et environ 650 nm, comprise entre environ 780 nm et environ 830 nm, comprise entre environ 910 nm et environ 1100 nm, comprise entre environ 1450 nm à environ 1550 nm, et comprise entre environ 1600 nm à environ 1900 nm.

2. Système selon la revendication 1, dans lequel le premier diviseur de faisceau (3), pour un faisceau lumineux incident (2) ayant une longueur d'onde dans la plage de longueur d'onde prédéterminée, provoque une variation de la puissance du faisceau lumineux secondaire (5) transmis/réfléchi étant à +/- 10% de la puissance moyenne du faisceau lumineux secondaire (5) transmis/réfléchi dans la plage de longueur d'onde donnée de façon à fournir une variation du pourcentage essentiellement fixe du faisceau lumineux de sortie primaire (4) étant à +/- 10% de la puissance moyenne du faisceau lumineux de sortie secondaire (5) transmis/réfléchi dans la plage de longueur d'onde prédéterminée.

3. Système selon la revendication 1, dans lequel le premier diviseur de faisceau (3), pour un faisceau lumineux incident (2) ayant une longueur d'onde dans la plage de longueur d'onde prédéterminée, provoque une variation de la puissance du faisceau lumineux secondaire (5) transmis/réfléchi étant à +/- 5% de la puissance du faisceau lumineux secondaire (5) transmis/réfléchi à une longueur d'onde donnée dans la plage de longueur d'onde prédéterminée de façon à fournir une variation du pourcentage essentiellement fixe du faisceau lumineux de sortie primaire (4) étant à +/- 5% du pourcentage essentiellement fixe à la donnée longueur d'onde.

4. Système selon la revendication 1, dans lequel le premier diviseur de faisceau (3), pour un faisceau lumineux incident (2) ayant une longueur d'onde dans la plage de longueur d'onde prédéterminée, provoque une variation de la puissance du faisceau lumineux secondaire (5) transmis/réfléchi étant à +/- 5% de la puissance moyenne du faisceau lumineux de sortie secondaire (5) transmis/réfléchi dans la plage de longueur d'onde donnée de façon à fournir une variation du pourcentage essentiellement fixe du faisceau lumineux de sortie primaire (4) étant à +/- 5% de la puissance moyenne du faisceau lumineux de sortie secondaire (5) transmis/réfléchi dans la plage de longueur d'onde prédéterminée.

5. Système selon la revendication 1, dans lequel la puissance de sortie du faisceau lumineux de sortie primaire (4) est maintenue à +/- 20% d'une puissance de sortie prédéterminée.

6. Système selon la revendication 1, dans lequel la puissance de sortie du faisceau lumineux de sortie primaire (4) est maintenue à +/- 10% de la puissance de sortie prédéterminée.

7. Système selon l'une quelconque des revendications 1-6, dans lequel la transmission et/ou les spectres de réflexion du revêtement diélectrique du diviseur de faisceau (3) est/sont essentiellement invariant(s) à des changements de température du revêtement diélectrique.

8. Système selon l'une quelconque des revendications 1-7, dans lequel le pourcentage essentiellement fixe est essentiellement inférieur à 0,5%.

9. Système selon l'une quelconque des revendications 1-8, dans lequel le pourcentage essentiellement fixe est essentiellement inférieur à 0,1%.

10. Système selon l'une quelconque des revendications 1-9, dans lequel la source de lumière (1) comprend une source de lumière laser à l'état solide.

11. Système selon l'une quelconque des revendications 1-10, dans lequel la source de lumière (1) comprend une source de lumière laser accordable à longueur d'onde.

12. Système selon l'une quelconque des revendications 1-11, dans lequel le revêtement diélectrique comprend une pluralité de couches alternantes ayant différents indices de réfraction.

13. Système selon la revendication 12, dans lequel chacune des couches alternantes présente un indice de réfraction étant significatif de ladite couche.

14. Système selon la revendication 12 ou 13, dans lequel les indices de réfraction des couches alternantes étant dans une plage d'environ 1,2 à environ 2,5.

15. Système selon l'une quelconque des revendications 12 - 14, dans lequel le revêtement diélectrique comprend au moins une première couche ayant un indice de réfraction se situant dans une plage allant d'environ 1,2 à environ 1,6, et au moins une deuxième couche ayant un indice de réfraction se situant dans une plage d'environ 2,0 à environ 2,5.

16. Système selon l'une quelconque des revendications 1-15, dans lequel le revêtement diélectrique comprend des couches alternantes de dioxyde de titane (TiO₂) et le quartz (SiO₂).

17. Système selon l'une quelconque des revendications 1-16, dans lequel la teneur en eau du revêtement diélectrique est réduite au minimum.

18. Procédé de commande de la sortie d'un système optique, le procédé comprenant les étapes consistant à:
- émettre, au moyen d'une source de lumière (1), un premier faisceau lumineux (2) étant incident sur un diviseur de faisceau (3),
- refléter/transmettre un faisceau lumineux de sortie primaire (4) au moyen dudit diviseur de faisceau (3) en réponse au premier faisceau lumineux (2) étant incident sur celui-ci,
- transmettre/réfléchir un faisceau lumineux de sortie secondaire (5) au moyen dudit diviseur de faisceau (3) en réponse audit premier faisceau lumineux (2) étant incident sur celui-ci, et d'une telle manière que la puissance du faisceau lumineux de sortie secondaire (5) étant un pourcentage essentiellement fixe de la puissance du faisceau lumineux de sortie primaire (4), le pourcentage essentiellement fixe étant inférieure à 5%, le pourcentage essentiellement fixe étant essentiellement invariant à des variations de longueur d'onde du premier faisceau lumineux (2) dans une plage prédéterminée de longueur d'onde,
- mesurer la puissance du faisceau lumineux de sortie secondaire (5),
- fournir, sur la base de la puissance mesurée, un signal de commande à la source de lumière (1), et
- ajuster des paramètres de la première source de lumière (1) si bien que le premier faisceau lumineux (2) est émis d'une telle manière que la puissance de sortie du faisceau lumineux de sortie primaire (4) est maintenue essentiellement constante,
**caractérisé en ce que**
- le premier diviseur de faisceau (3) présente un revêtement diélectrique,
- le premier diviseur de faisceau (3), pour un faisceau lumineux incident (2) ayant une longueur d'onde dans la plage de longueur d'onde prédéterminée, est adapté de manière à provoquer une variation de la puissance du faisceau lumineux de sortie secondaire (5) transmis/réfléchi étant à +/- 10% de la puissance du faisceau lumineux de sortie secondaire (5) transmis/réfléchi à une longueur d'onde donnée dans la plage de longueur d'onde prédéterminée de façon à fournir une variation du pourcentage essentiellement fixe du faisceau lumineux de sortie primaire (4) étant à +/- 10% du pourcentage essentiellement fixe à la donnée longueur d'onde, et
- la plage de longueur d'onde prédéterminée est choisie d'un groupe composé des plages de longueur d'onde: comprise entre environ 520 nm et environ 585 nm, comprise entre environ 620 nm et environ 650 nm, comprise entre environ 780 nm et environ 830 nm, comprise entre environ 910 nm et environ 1100 nm, comprise entre environ 1450 nm à environ 1550 nm, et comprise entre environ 1600 nm à environ 1900 nm.

19. Procédé selon la revendication 18, dans lequel le premier diviseur de faisceau (3), pour un faisceau lumineux incident (2) ayant une longueur d'onde dans la plage de longueur d'onde prédéterminée, est adapté de manière à provoquer une variation de la puissance du faisceau lumineux secondaire (5) transmis/réfléchi étant à +/- 10% de la puissance moyenne du faisceau lumineux de sortie secondaire (5) transmis/réfléchi dans la plage de longueur d'onde donnée de façon à fournir une variation du pourcentage essentiellement fixe du faisceau lumineux de sortie primaire (4) étant à +/- 10% de la puissance moyenne du faisceau lumineux de sortie secondaire (5) transmis/réfléchi dans la plage de longueur d'onde prédéterminée.

20. Procédé selon la revendication 18, dans lequel le premier diviseur de faisceau (3), pour un faisceau lumineux incident (2) ayant une longueur d'onde dans la plage de longueur d'onde prédéterminée, est adapté de manière à provoquer une variation de la puissance du faisceau lumineux secondaire (5) transmis/réfléchi étant à +/- 5% de la puissance du faisceau lumineux secondaire (5) transmis/réfléchi à une longueur d'onde donnée dans la plage de longueur d'onde prédéterminée de façon à fournir une variation du pourcentage essentiellement fixe du faisceau lumineux de sortie primaire (4) étant à +/- 5% du pourcentage essentiellement fixe à la donnée longueur d'onde.

21. Procédé selon la revendication 18, dans lequel le premier diviseur de faisceau (3), pour un faisceau lumineux incident (2) ayant une longueur d'onde dans la plage de longueur d'onde prédéterminée, est adapté de manière à provoquer une variation de la puissance du faisceau lumineux secondaire (5) transmis/réfléchi étant à +/- 5% de la puissance moyenne du faisceau lumineux secondaire (5) transmis/réfléchi dans la plage de longueur d'onde donnée de façon à fournir une variation du pourcentage essentiellement fixe du faisceau lumineux de sortie primaire (4) étant à +/- 5% de la puissance moyenne du faisceau lumineux de sortie secondaire (5) transmis/réfléchi dans la plage de longueur d'onde prédéterminée.

22. Procédé selon la revendication 18, dans lequel la puissance de sortie du faisceau lumineux de sortie primaire (4) est maintenue à +/- 20% d'une puissance de sortie prédéterminée.

23. Procédé selon la revendication 18, dans lequel la puissance de sortie du faisceau lumineux de sortie primaire (4) est maintenue à +/- 10% de la puissance de sortie prédéterminée.

24. Procédé selon l'une quelconque des revendications 18-23, dans lequel la transmission et/ou les spectres de réflexion de revêtement diélectrique du diviseur de faisceau (3) est/sont essentiellement invariant(s) à des changements de température du revêtement diélectrique.

25. Procédé selon l'une quelconque des revendications 18-24, dans lequel le pourcentage essentiellement fixe est égal ou inférieur à 0,5%.

26. Procédé selon l'une quelconque des revendications 18-25, dans lequel le pourcentage essentiellement fixe est égal à ou inférieur à 0,1%.

27. Procédé selon l'une quelconque des revendications 18-26, dans lequel le revêtement diélectrique comprend des couches alternantes de dioxyde de titane (TiO₂) et le quartz (SiO₂).

28. Procédé selon l'une quelconque des revendications 18-27, dans lequel la teneur en eau du revêtement diélectrique est réduite au minimum.
